(19) Europäisches Patentamt
European Patent Office
Office européen des brevets

(11) **EP 1 638 207 B1**

(12) **EUROPEAN PATENT SPECIFICATION**

(45) Date of publication and mention
of the grant of the patent:
**20.02.2008 Bulletin 2008/08**

(51) Int Cl.:
**H03L 7/099** (2006.01)     **H03L 7/10** (2006.01)
**H03L 7/187** (2006.01)

(21) Application number: **04425685.7**

(22) Date of filing: **15.09.2004**

(54) **Method of calibrating the frequency of an oscillator in a phase locked loop circuit**

Methode zum Kalibrieren der Frequenz eines Oszillators in einer Phasenregelschleife

Procédé de calibrage de la fréquence d'un oscillateur dans une boucle à verrouillage de phase

(84) Designated Contracting States:
**DE FR GB IT**

(43) Date of publication of application:
**22.03.2006 Bulletin 2006/12**

(73) Proprietor: **STMicroelectronics S.r.l.**
**20041 Agrate Brianza (Milano) (IT)**

(72) Inventors:
 • **Filocamo, Basilio**
 **98100 Messina (IT)**
 • **Gramegna, Giuseppe**
 **95100 Catania (IT)**

(74) Representative: **Mittler, Enrico**
**Mittler & C. s.r.l.,**
**Viale Lombardia, 20**
**20131 Milano (IT)**

(56) References cited:
 **WO-A-03/044961**     **US-A- 6 114 920**

 • **YASUNAGA T ET AL INSTITUTE OF ELECTRICAL AND ELECTRONICS ENGINEERS: "A fully integrated PLL frequency synthesizer LSI for mobile communication system" 2001 IEEE RADIO FREQUENCY INTEGRATED CIRCUITS (RFIC) SYMPOSIUM. DIGEST OF PAPERS. PHOENIX, AZ, MAY 20 - 22, 2001, IEEE RADIO FREQUENCY INTEGRATED CIRCUITS SYMPOSIUM, NEW YORK, NY : IEEE, US, 20 May 2001 (2001-05-20), pages 65-68, XP010551323 ISBN: 0-7803-6601-8**

**Description**

The present invention refers to a method for calibrating the frequency of an oscillator of a phase-locked loop circuit.

In the current radiocommunication systems phase-locked loop circuits (PLL) are generally used for the generation of oscillating electric signals. Generally PLL comprise a voltage-controlled oscillator (VCO) that generates an output oscillating signal in response to a level of input voltage. The specific parameters of the voltage/frequency ratio of a VCO depend on the process parameters for the production of the VCO, on the value of the electric components that it comprises, on the ambient temperature and on other factors.

Devices for calibrating the VCO frequency are currently used to reduce the effects of the variations of the temperature and of the process parameters.

These devices become very important for the following reasons.

The reduction of the dimensions of the integrated circuits due to the generation of MOS transistor with smaller and smaller channels requires a reduction of the supply voltage and, therefore, a reduction of the input voltage of the VCO.

The need to increase the rejection of the emissions of spurious radiations in a PLL and the risk of frequency variations of the VCO due to the interferences for the coupling with the rest of the circuitry in the case of producing a complex system on chip, requires a reduction of the gain of the VCO.

A PLL with a device for calibrating the frequency in a VCO is described in the article "A Fully Integrated PLL Frequency Synthesizer LSI for Mobile Communication System.", 2001 IEEE Radio Frequency Integrated Circuits Symposium, pages 65-68. The PLL device comprises a programmable divider, a phase comparator, a filter, a delta-sigma converter, a VCO and a frequency error detector. The frequency band of the VCO is selected by a digital control signal and the resonant circuit of the VCO has N operating frequency bands. Once the new frequency data are sent to the PLL, the VCO has a constant input voltage. One of the N bands of the resonant circuit is selected in response to a digital starting signal and the VCO oscillates at a frequency f1 that is sent to the programmable divider having in input the output signal of the sigma-delta converter; the output signal of the programmable divider is the signal fdiv. The error detector compares the frequency fdiv with a reference frequency fref and generates a new digital signal to select another frequency band of the VCO. The process is repeated several times until the frequency difference between the signal fdiv and the signal fref is lower than a preset value. Once the correct frequency band of the VCO has been determined, the VCO has no longer a constant input signal but an output signal from the filter so as to make the PLL act in closed loop conditions.

The precision of the calibration of the frequency in said device is dictated by the number of bits of the digital signal; nevertheless the use of a digital signal with a large number of bits leads to a lengthening of the time for the convergence of the calibration technique. A compromise is therefore needed between the number of bits of the digital signal and the convergence tim of the calibration technique.

US 6114920 discloses a circuit, such as a phase-lock loop (PLL), which has an oscillator having a plurality of operating curves. During circuit auto-trim operations, the oscillator is automatically trimmed to an appropriate oscillator operating curve for use during normal circuit operations. In particular PLL embodiments, the PLL is a charge-pump PLL having a phase/frequency detector (PFD) that generates error signals based on comparing an input signal and a PLL feedback signal; a charge pump that generates amounts of charge corresponding to the error signals; a loop filter that accumulates the amounts of charge to generate a loop-filter voltage; and a voltage-controlled oscillator (VCO), where the VCO output signal is used to generate the PLL feedback signal. During normal PLL operations, the loop-filter voltage is applied to the voltage input of the VCO. During the PLL auto-trim operations, a state machine applies a sequence of digital control input values to the VCO to select different VCO operating curves until an appropriate operating curve for the present PLL application is found. In different embodiments, the state machine uses different signals to determine whether the center frequency of each operating curve in the sequence is above or below the desired nominal operating frequency for the VCO, and select one such operating curve for use in normal operations. The present invention can also be implemented in circuits having self-calibrating oscillators, other than PLLs.

WO 03/044961 discloses an oscillator (VCO) of a PLL circuit which can operate in a plurality of frequency bands. With a control voltage of the oscillator fixed to a predetermined value, an oscillation frequency of the oscillator is measured for each band to be stored in a storage. When the PLL operates, a setting value to specify a band is compared with the measured frequency values stored in the storage. As a result of the comparison, a band to be actually used by the oscillator is determined.

In view of the state of the technique described, object of the present invention is to provide a method for calibrating the frequency of an oscillator of a phase-locked loop circuit that is faster than known methods.

In accordance with the present invention, this object is achieved by means of a method for calibrating the frequency of an oscillator of a phase-locked loop circuit, as defined in claim 1.

Thanks to the present invention a method for calibrating the frequency of an oscillator in a phase-locked loop circuit can be produced that permits the use of a reduced supply voltage and a VCO with a reduced voltage/frequency gain as required by the current systems of radio communications.

The characteristics and the advantages of the present invention will appear evident from the following detailed description of an embodiment thereof, illustrated as non-limiting example in the enclosed drawings, in which:

Figure 1 is a schematic view of a phase-locked loop circuit comprising a voltage-controlled oscillator and a device for calibrating the frequency of the oscillator that operates in accordance with the method of the present invention;

Figure 2 is a flow diagram representing the method for calibrating the frequency of the oscillator of the circuit of Figure 1;

Figure 3 is a graph of the frequency of oscillation of the VCO 2 on the basis of the digital signals applied.

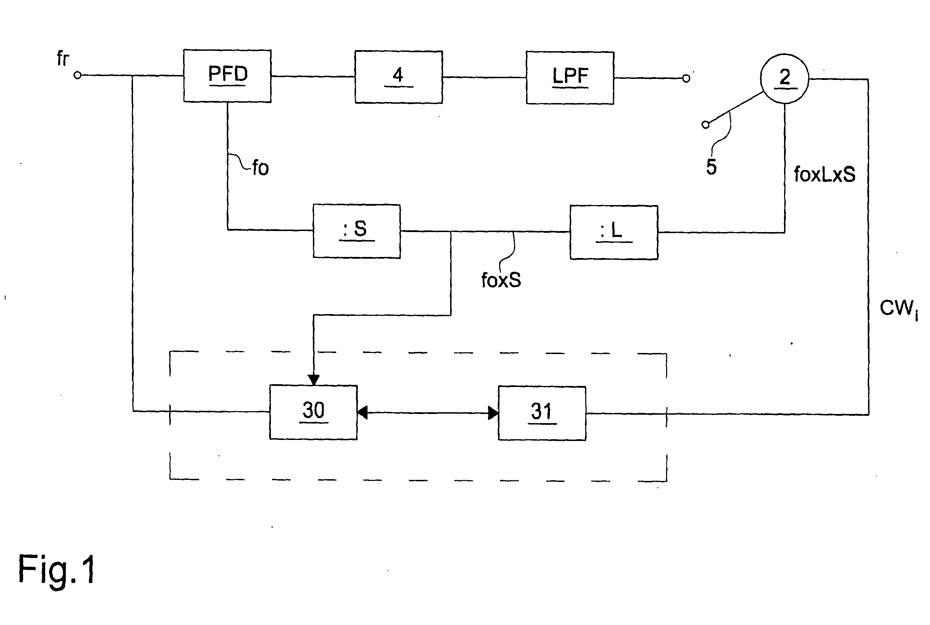

With reference to Figure 1 a PLL 1 comprising a VCO 2 and a device 3 for calibrating the frequency of the VCO 2 are shown. The PLL comprises a phase detector PDF suitable for detecting the phase difference between the reference input frequency fr and the frequency fo; the voltage output signal of the PDF is sent to a charge pump 4 whose output signal is filtered by a low-pass filter LPF. The VCO 2 can have as voltage input level either a reference voltage Vref or the voltage output signal of the filter LPF; there is a switch 5 that can be positioned on the reference voltage Vref or on the output signal of the filter LPF.

The VCO 2 has an oscillation frequency given by L*S*fo that is calibrated by a digital signal $CW_i$ in output from the device 3. The device 3 comprises a variable module counter 30 and a logic block 31; the variable module counter 30 has in input a first reference frequency fr and a second frequency proportional to the output frequency S*fo of the oscillator 2. The counter 30 is capable of counting the output frequency S*fo in a variable period of time Ti, that is a period of time that increases at every successive counting cycle up to a preset period Tn where n indicates the resolution of the counter.

The apparatus for calibrating the frequency operates in the following manner.

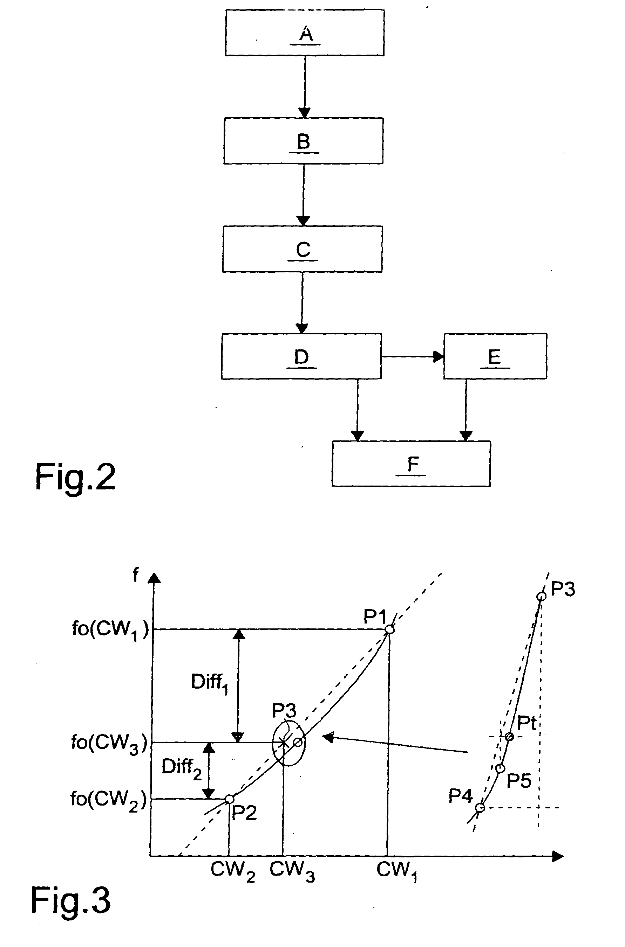

In the initial phase A (Figure 2) the circuitry 31 places the switch 5 on the reference voltage Vref; in the phase B the circuitry 31 sends the digital signal $CW_1$ corresponding preferably to the highest (digital signal CW high) frequency that can be set on the same VCO 2, that is one of the frequencies that limit the operative range of the VCO 2. The counter 30 counts the frequency S*fo ($CW_1$) in a first period of time T1 given by the reciprocal of the reference frequency fr obtaining a count $N_1$. In the phase C the circuitry 31 sends the digital signal $CW_2$ corresponding preferably to the lower (digital signal CW low) frequency that can be set on the same VCO and the counter 30 counts the new frequency S*fo ($CW2$) in a second period of time greater than the first period of time T2 and given by the reciprocal of the frequency fr/2 obtaining a count $N_2$. In the phase D the circuitry 31 sets a new digital signal $CW_3$ that is function of the difference between the two previous digital signals $CW_1$ and $CW_2$. More precisely the new digital signal $CW_3$ is linked to the previous signals and to the respective oscillation frequencies of the VCO 2 according to a function that approximates the functioning of the same oscillator 2. In particular said link can be of the linear type as shown in Figure 2. In this case considering the points P1 and P2 obtained by means of the digital signals $CW_1$ and $CW_2$ and the respective frequencies fo($CW_1$) and fo($CW_2$) of oscillation of the VCO 2, it is possible to trace the slope $1/Sb_3$ of the line joining the two points P1 and P2 and it is possible to multiply said slope by the difference to compensate. The digital signal $CW_3$ is thus given by:

$$CW_3 = CW_2 \pm \frac{Diff_2}{Sb_3}$$

where

$$Sb_3 = \frac{Diff_2 - Diff_1}{|CW_1 - CW_2|} \; , \; Diff_2 = \frac{S \times ft}{fr_2} - N_2 \; \text{and} \; Diff_1 = 2 \times \left( \frac{S \times ft}{fr} - N_1 \right)$$

with $fr_2 = fr/2$. It is derived that

$$CW_3 = CW_2 \pm \frac{|CW_1 - CW_2|}{fo(CW_1) - fo(CW_2)} \left( ft - fo(CW_2) \right)$$

that is the new digital signal $CW_3$ depends on the sum of the previous digital signal $CW_2$ and on the difference between the target frequency ft and the oscillation frequency corresponding to the signal $CW_2$ multiplied by the ratio between the difference of the previous digital signals and the difference between the previous corresponding oscillation frequencies.

The digital signal $CW_3$ corresponds to an output frequency of the oscillator that is proportional to the target frequency ft set externally or to a frequency near the frequency ft. If the output frequency from the oscillator S*fo is a frequency near the frequency S*ft or the maximum preset period Tn has not been reached, the digital signal is changes as in the third phase in the new phase E, that is a new digital signal is set according to the general formula

$$CW_i = CW_{i-1} \pm \frac{Diff_{i-1}}{Sb_i}$$

where

$$Sbi = \frac{Diff_{i-2} - Diff_{i-1}}{|CW_{i-2} - CW_{i-1}|}$$

with

$$Diff_{i-1} = \frac{S \times ft}{fr_{i-1}} - N_{i-1}$$

and

$$Diff_{i-2} = 2 \times \left( \frac{S \times ft}{fr_{i-2}} - N_{i-2} \right),$$

where $fr_i = fr/2^{i-1}$ with $Ti = 1/fr_i$; i is a whole number with i=3,...n where n is the index of the maximum period possible Tn set in the counter 30 to be able to count the frequencies S*fo. It is derived that

$$CW_i = CW_{i-1} \pm \frac{|CW_{i-2} - CW_{i-1}|}{fo(CW_{i-2}) - fo(CW_{i-1})} (ft - fo(CW_{i-1}))$$

that is the new digital signal $CW_i$ depends on the sum of the previous digital signal $CW_{i-1}$ and on the difference between the target frequency ft and the oscillation frequency corresponding to the signal $CW_{i-1}$ multiplied by the ratio between the difference the two previous digital signals and the difference between the two previous corresponding oscillation frequencies.

Therefore the process ends if the frequency fo corresponding to the digital signal $CW_i$ is the frequency ft or if the frequency $fr_n = fr/2^{n-1}$ is reached with $fo(CW_n)$ corresponding to the digital signal $CW_n$ where the frequency fo is near the frequency ft; in the latter case the end of the process is dictated by the resolution of the counter 30. The logic circuitry 31 places the switch 5 on the output signal of the filter LPF in the phase F. After said instant the PLL1 can operate like a known PLL.

Figure 3 shows a graph of the oscillation frequencies of the oscillator 2 in function of the digital signals $CW_i$. The points P1...Pn indicate the various points that are obtained with the digital signals $CW_1...CW_n$ in abscissa and the frequencies $fo(CW_1).....fo(CW_n)$ in ordinate. It can be noted that already with the digital signal $CW_3$ an oscillation frequency near the frequency ft. are obtained. With the successive digital signals $CW_4$, $CW_5$ an oscillation frequency nearly the same as the frequency ft is obtained; in the zoom of the graph it can be seen that the point P5 is near the point Pt relating to the frequency ft.

For example if we establish that the target frequency ft=256Mhz and we establish initially the digital signal $CW_1$=63 to which a frequency L*fo=340Mhz and a reference frequency fr=32Mhz correspond, there is a count $N_1$=10 with an error on reading the count equal to 10%.

If we establish $CW_2$=0 to which a frequency L*fo=240Mhz corresponds and we make said frequency count in a period of time given by the reciprocal of fr/2, a count $N_2$=15 is obtained. Preferably the frequencies 340Mhz and 240Mhz are the maximum and the minimum operative frequency of the VCO 2.

Now we can establish a digital signal $CW_3$ which is function of the difference of the previous digital signals and preferably of the previous oscillation frequencies obtaining an oscillation frequency S*fo that is equal to or near the target frequency S*ft. In particular we can establish a $CW_3$ given by

$$CW_i = CW_{i-1} \pm \frac{Diff_{i-1}}{Sb_i}$$

where

$$Sbi = \frac{Diff_{i-2} - Diff_{i-1}}{|CW_{i-2} - CW_{i-1}|}$$

with

$$Diff_{i-1} = \frac{S \times ft}{fr_{i-1}} - N_{i-1}$$

and

$$Diff_{i-2} = 2 \times \left( \frac{S \times ft}{fr_{i-2}} - N_{i-2} \right).$$

where $fr_i = fr/2^{i-1}$ with $Ti=1/fr_i$.

$Diff_1$=-4, $Diff_2$=1, $Sb_3$=5/63 and $CW_3$=12,6 is obtained to which a frequency S*fo=264,762 corresponds. Counting said frequency in a period of time given by the reciprocal of fr/4, a count $N_3$=33 is obtained.

We establish a new digital signal $CW_4$ calculated by means of the previous formula; $Diff_2$=2, $Diff_3$=-1, $Sb_4$=5/63 and $CW_4$=8 is obtained to which the frequency S*fo=252,698Mhz corresponds. Counting said frequency in a period of time given by the reciprocal of fr/8, a count $N_4$=63 is obtained.

Calculating the new digital signal $CW_5$ by means of the previous formula $CW_5$=9 is obtained to which a frequency S*fo=254,286Mhz corresponds. Counting said frequency in a period of time given by the reciprocal of fr/16, a count $N_5$=127 is obtained.

Calculating the new digital signal $CW_6$ by means of the previous formula $CW_6$=10 is obtained to which a frequency S*fo=255,873Mhz corresponds. The time used to arrive at said frequency is 1,47us and the error is 0,79%.

## Claims

1. Method for calibrating the frequency of an oscillator (2) of a phase-locked loop circuit, said phase-locked loop circuit comprising a phase detector (PDF) suitable for determining the phase difference between a reference frequency (fr) and a loop feedback frequency proportional to an output frequency of said oscillator (2) and suitable for generating a signal in response to said phase difference,

   said oscillator (2) having a first and a second input and generating said output frequency (fo*L*S) in response to a first voltage signal normally applied to said first input, said first voltage signal being produced by a low-pass filter (LPF) coupled with the output signal of said phase detector (PFD),
said method comprising the application (A) of a reference voltage signal (Vref) to the first input of said oscillator (2) instead of the first voltage signal and the generation of a digital signal (CW$_i$) applied to said second input of the oscillator (2) to calibrate its output frequency,
**characterised in that**
said circuit comprises at least a counter (30) counting an intermediate feedback signal (S*fo) and said reference signal (fr) for obtaining a count number (N$_i$) and **in that** said method comprises
a first phase (B) in which a first output frequency (L*S*fo) of the oscillator (2) is generated on the basis of a first value (CW$_1$) of the digital signal applied for obtaining a first count number (N1) given by the ratio of a first reference frequency (fr) and of a first intermediate feedback frequency (S*fo) proportional to the first output frequency of the oscillator (2),
a second phase (C) in which a second output frequency (L*S*fo) of the oscillator is generated on the basis of a second value (CW$_2$) of the digital signal applied for obtaining a second count number (N$_2$) given by the ratio of a second reference frequency (fr/2) proportional to and lower than the reference frequency and of a second intermediate feedback frequency (S*fo) proportional to the second output frequency of the oscillator,
a third phase (D) in which a third output frequency (L*S*fo) of the oscillator is generated on the basis of a third value (CW$_3$) of the digital signal, said third value (CW$_3$) of the digital signal being a function of the difference of the two previous digital signals (CW$_1$, CW$_2$)and of the two previous count numbers (N1, N2) for obtaining a third count number (N3) given by the ratio of a third reference frequency (fr/4) proportional to and lower than the second reference frequency and of a third intermediate feedback frequency (S*Fo) proportional to the third output frequency of the oscillator (L*S*fo),
a fourth phase (E) to change the value of the digital signal into further values (CW$_i$) if the intermediate feedback frequency (S*Fo) proportional to the output frequency of the oscillator is not equal to a preset intermediate feedback frequency (S*ft) or if the previous reference frequency proportional to the reference frequency is not equal to a preset reference frequency (fr$_n$),
said fourth phase (E) consisting of repeating the third phase (D) several times until said intermediate feedback frequency (S*fo) proportional to the output frequency of the oscillator becomes equal to the preset intermediate feedback frequency (S*ft) or until said previous reference frequency proportional to the reference frequency becomes equal to said preset reference frequency (fr$_n$),
and a fifth phase in which the first voltage signal is applied to the first input of said oscillator (2).

2. Method according to claim 1, **characterised in that** said oscillator (2) has a field of operative frequencies and said first phase comprises the setting of the first value of the digital signal (CW$_1$) at the value corresponding to the highest value of the frequencies of said field of operative frequencies and said second phase comprises the setting of the second value of the digital signal (CW$_1$) at the value corresponding to the lowest value of the frequencies of said field of operative frequencies.

3. Method according to claim 1, **characterised in that** said oscillator (2) has a field of operative frequencies and said first phase comprises the setting of the first value of the digital signal (CW$_1$) at the value corresponding to the lowest value of the frequencies of said field of operative frequencies and said second phase comprises the setting of the second value of the digital signal (CW$_1$) at the value corresponding to the highest value of the frequencies of said field of operative frequencies.

4. Method according to claim 1, **characterised in that** the further value of the digital signal (CW$_i$) is linked to the values of the first and second digital signals (CW$_{i-1}$, CW$_{i-2}$) and to the values of the respective output frequencies (S*fo(CW$_{i-1}$), S*fo(CW$_{i-2}$))of the oscillator according to a function that approximates the functioning of the same oscillator (2).

5. Method according to claim 1, **characterised in that** the values (fr/2$^{i-1}$) of said second and third reference frequency are given by the first reference frequency (fr) divided by 2$^{i-1}$, where i is a whole number.

6. Method according to claim 1, **characterised in that** the value of the further digital signal (CW$_i$) the third and of the fourth phase is linked to the values of the first and second digital signals (CW$_{i-1}$, CW$_{i-2}$) and to the respective output frequencies (S*fo(CW$_{i-1}$), S*fo(CW$_{i-2}$))of the oscillator according to a linear function (2).

7. Method according to claim 6, **characterised in that** the further value of the digital signal depends on the sum of the second digital signal (CW$_{i-1}$) and on the difference between the target frequency (ft) and the output frequency of the oscillator corresponding to the second digital signal (CW$_{i-1}$) multiplied by the ratio between the difference of the second and the first digital signals ($CW_{i-1}$, $CW_{i-2}$) and the difference between the two corresponding output frequencies ($fo(CW_{i-1})$, $fo(CW_{i-2})$)of the oscillator.

8. Method according to claim 7, **characterised in that** the value of the further digital signal ($CW_3$) is defined by the following equation

$$CW_i = CW_{i-1} \pm \frac{Diff_{i-1}}{Sb_i}$$

where

$$Sbi = \frac{Diff_{i-2} - Diff_{i-1}}{\left| CW_{i-2} - CW_{i-1} \right|}$$

with

$$Diff_{i-1} = \frac{S \times ft}{fr_{i-1}} - N_{i-1} \quad \text{and} \quad Diff_{i-2} = 2 \times \left( \frac{S \times ft}{fr_{i-2}} - N_{i-2} \right)$$

where i is a variable whole number from 3 to n, where with $CW_i$ the i-umpteenth digital signal is indicated, where $fr_i = fr/2^{i-1}$ where fr is the reference frequency, where $N_i$ is the count relating to the ratio between the output frequency of the oscillator relating to the digital signal $CW_i$ and the frequency $fr_i$ and is a whole number, where with $S \times ft$ indicates the oscillation frequency of the oscillator relating to the target frequency ft set externally.

**Patentansprüche**

1. Verfahren zum Kalibrieren der Frequenz eines Oszillators (2) einer phasenstarren Regelschaltung,
wobei die phasenstarre Regelschaltung einen zum Bestimmen der Phasendifferenz zwischen einer Bezugsfrequenz (fr) und einer einer Ausgangsfrequenz des Oszillators (2) proportionalen Schleifen-Rückkopplungsfrequenz geeigneten und zum Erzeugen eines Signals in Abhängigkeit von der Phasendifferenz geeigneten Phasendetektor (PDF) umfasst,
wobei der Oszillator (2) einen ersten und einen zweiten Eingang aufweist und die Ausgangsfrequenz (fo*L*S) in Abhängigkeit von einem ersten Spannungssignal, das normalerweise an den ersten Eingang angelegt wird, erzeugt,
wobei das erste Spannungssignal durch einen mit dem Ausgangssignal des Phasendetektors (PFD) gekoppelten Tiefpassfilter (LPF) erzeugt wird,
wobei das Verfahren das Anlegen (A) eines Bezugsspannungssignals (Vref) anstelle des ersten Spannungssignals an den ersten Eingang des Oszillators (2) und das Erzeugen eines zum Kalibrieren seiner Ausgangsfrequenz an den zweiten Eingang des Oszillators (2) angelegten digitalen Signals ($CW_i$) beinhaltet,
**dadurch gekennzeichnet, dass**
die Schaltung mindestens einen ein intermediäres Rückkopplungssignal (S*fo) und das Bezugssignal (fr) zum Gewinnen einer Zählzahl ($N_i$) zählenden Zähler (30) aufweist, und dadurch, dass das Verfahren umfasst:

eine erste Phase (B), in welcher eine erste Ausgangsfrequenz (L*S*fo) des Oszillators (2) auf der Basis eines ersten Wertes ($CW_1$) des zum Erhalten einer durch das Verhältnis einer ersten Bezugsfrequenz (fq) zu einer ersten intermediären Rückkopplungsfrequenz (S*fo) proportional zu der ersten Ausgangsfrequenz des Oszillators (2) gegebenen ersten Zählzahl (N1) angelegten digitalen Signals erzeugt wird,
eine zweite Phase (C), in welcher eine zweite Ausgangsfrequenz (L*S*fo) des Oszillators auf der Basis eines zweiten Wertes ($CW_2$) des zum Erhalten einer durch das Verhältnis einer zweiten Bezugsfrequenz (fr/2) proportional zu und kleiner als die Bezugsfrequenz zu einer zweiten intermediären Rückkopplungsfrequenz (S*fo) proportional zu der zweiten Ausgangsfrequenz des Oszillators gegebenen zweiten Zählzahl ($N_2$) angelegten digitalen Signals erzeugt wird,

eine dritte Phase (D), in der eine dritte Ausgangsfrequenz (L\*F\*fo) des Oszillators auf der Basis eines dritten Wertes (CW$_3$) des digitalen Signals erzeugt wird, wobei der dritte Wert (CW$_3$) des digitalen Signals eine Funktion der Differenz der zwei vorhergehenden Digitalsignale (CW1, CW$_2$) und der beiden vorhergehenden Zählerzahlen (N1, N2) zum Erzielen einer durch das Verhältnis einer dritten Bezugsfrequenz (fr/4) proportional zu und kleiner als die zweite Bezugsfrequenz zu einer dritten intermediären Rückkopplungsfrequenz (S\*Fo) proportional zu der dritten Ausgangsfrequenz des Oszillators (L\*S\*fo) gegebenen dritten Zählzahl (N3),

eine vierte Phase (E) zum Ändern des Wertes des Digitalsignals in weitere Werte (CW$_i$), wenn die intermediären Rückkopplungsfrequenz (S\*Fo) proportional der Ausgangsfrequenz des Oszillators nicht gleich einer voreingestellten Rückkopplungs-Zwischenfrequenz (S\*ft) ist oder wenn die vorherige Bezugsfrequenz proportional der Bezugsfrequenz nicht gleich einer voreingestellten Bezugsfrequenz (fr$_n$) ist,

wobei die vierte Phase (E) aus dem mehrmaligen Wiederholen der dritten Phase (D) besteht, bis die intermediäre Rückkopplungsfrequenz (S\*fo) proportional der Ausgangsfrequenz des Oszillators gleich der voreingestellten Rückkopplungs-Zwischenfrequenz (S\*ft) wird oder bis die vorherige Bezugsfrequenz proportional der Bezugsfrequenz gleich der voreingestellten Bezugsfrequenz (fr$_n$) wird,

und eine fünfte Phase, in welcher das erste Spannungssignal an den ersten Eingang des Oszillators (2) angelegt wird.

2. Verfahren nach Anspruch 1, **dadurch gekennzeichnet,**
**dass** der Oszillator (2) ein Feld von Betriebsfrequenzen aufweist und
**dass** die erste Phase das Einstellen des ersten Wertes des Digitalsignals (CW$_1$) auf den Wert entsprechend dem größten Wert der Frequenzen des Feldes von Betriebsfrequenzen beinhaltet und
**dass** die zweite Phase das Einstellen des zweiten Wertes des Digitalsignals (CW$_1$) auf den dem kleinsten Wert der Frequenzen aus dem Feld von Betriebsfrequenzen entsprechenden Wert beinhaltet.

3. Verfahren nach Anspruch 1, **dadurch gekennzeichnet,**
**dass** der Oszillator (2) ein Feld von Betriebsfrequenzen aufweist und
**dass** die erste Phase das Einstellen des ersten Wertes des Digitalsignals (CW$_1$) auf den Wert entsprechend dem kleinsten Wert der Frequenzen des Feldes von Betriebsfrequenzen beinhaltet und
**dass** die zweite Phase das Einstellen des zweiten Wertes des Digitalsignals (CW$_1$) auf den Wert entsprechend dem größten Wert der Frequenzen des Feldes von Betriebsfrequenzen umfasst.

4. Verfahren nach Anspruch 1, **dadurch gekennzeichnet, dass** der weitere Wert des Digitalsignals (CW$_i$) mit den Werten des ersten und des zweiten Digitalsignals (CW$_{i-1}$, CW$_{i-2}$) und mit den Werten der entsprechenden Ausgangsfrequenzen (S\*fo(CW$_{i-1}$), S\*fo(CW$_{i-2}$)) des Oszillators gemäß einer Funktion, die die Funktion desselben Oszillators (2) approximiert, verknüpft ist.

5. Verfahren nach Anspruch 1, **dadurch gekennzeichnet, dass** die Werte (fr/2$^{i-1}$) der zweiten und dritten Bezugsfrequenz durch die erste Bezugsfrequenz (fr) dividiert durch 2$^{i-1}$ gegeben sind, wobei i eine ganze Zahl ist.

6. Verfahren nach Anspruch 1, **dadurch gekennzeichnet, dass** der Wert des weiteren Digitalsignals (CW$_i$) der dritten und der vierten Phase mit den Werten des ersten und zweiten Digitalsignals (CW$_{i-1}$, CW$_{i-2}$) und mit den entsprechenden Ausgangsfrequenzen (S\*fo(CW$_{i-1}$), S\*fo(CW$_{i-2}$)) des Oszillators gemäß einer linearen Funktion (2) verknüpft ist.

7. Verfahren nach Anspruch 6, **dadurch gekennzeichnet, dass** der weitere Wert des Digitalsignals von der Summe des zweiten Digitalsignals (CW$_{i-1}$) und von der Differenz zwischen der Zielfrequenz (ft) und der Ausgangsfrequenz des Oszillators entsprechend dem zweiten Digitalsignal (CW$_{i-1}$) multipliziert mit dem Verhältnis zwischen der Differenz des zweiten und des ersten Digitalsignals (CW$_{i-1}$, CW$_{i-2}$) und der Differenz zwischen den beiden entsprechenden Ausgangsfrequenzen (fo(CW$_{i-1}$), fo(CW$_{i-2}$)) des Oszillators abhängt.

8. Verfahren nach Anspruch 7, **dadurch gekennzeichnet, dass** der Wert des weiteren Digitalsignals (CW$_3$) bestimmt ist durch die folgende Gleichung:

$$CW_i = CW_{i-1} \pm \frac{Diff_{i-1}}{Sb_i}$$

wobei

$$Sbi = \frac{Diff_{i-2} - Diff_{i-1}}{|CW_{i-2} - CW_{i-1}|}$$

mit

$$Diff_{i-1} = \frac{S \times ft}{fr_{i-1}} - N_{i-1} \quad \text{und} \quad Diff_{i-2} = 2 \times \left( \frac{S \times ft}{fr_{i-2}} - N_{i-2} \right)$$

wobei i eine veränderliche ganze Zahl von 3 bis n ist, wobei mit $CW_i$ das i-te Digitalsignal angegeben ist, wobei $fr_i = fr/2^{i-1}$ ist, wobei fr die Bezugsfrequenz ist, wobei $N_i$ die Zählung betreffend das Verhältnis zwischen der Ausgangsfrequenz des Oszillators betreffend das Digitalsignal $CW_i$ und die Frequenz $fr_i$ und eine ganze Zahl ist, wobei S x ft die Schwingungsfrequenz des Oszillators in Bezug auf die extern eingestellte Zielfreuenz ft angibt.

## Revendications

1. Procédé d'étalonnage de la fréquence d'un oscillateur (2) d'un circuit de boucle à asservissement de phase, ledit circuit de boucle à asservissement de phase comprenant un détecteur de phase (PDF) adapté pour déterminer la différence de phase entre une fréquence de référence (fr) et une fréquence de rétroaction de boucle proportionnelle à une fréquence de sortie dudit oscillateur (2) et adapté pour générer un signal en réponse à ladite différence de phase, ledit oscillateur (2) ayant une première et une deuxième entrée et générant ladite fréquence de sortie (fo*L*S) en réponse à un premier signal de tension normalement appliqué à ladite première entrée, ledit premier signal de tension étant produit par un filtre passe-bas (LPF) couplé au signal de sortie dudit détecteur de phase (PFD), ledit procédé comprenant l'application (A) d'un signal de tension de référence (Vref) à la première entrée dudit oscillateur (2) à la place du premier signal de tension et la génération d'un signal numérique ($CW_i$) appliqué à ladite deuxième entrée de l'oscillateur (2) pour étalonner sa fréquence de sortie, **caractérisé en ce que** :

   ledit circuit comprend au moins un compteur (30) comptant un signal de rétroaction intermédiaire (S*fo) et ledit signal de référence (fr) pour obtenir un nombre de comptage($N_i$) et **en ce que** ledit procédé comprend :

   une première phase (B) dans laquelle une première fréquence de sortie (L*S*fo) de l'oscillateur (2) est générée sur la base d'une première valeur ($CW_1$) du signal numérique appliqué pour obtenir un premier nombre de comptage (N1) donné par le rapport d'une première fréquence de référence (fr) et d'une première fréquence de rétroaction intermédiaire (S*fo) proportionnelle à la première fréquence de sortie de l'oscillateur (2),
   une deuxième phase (C) dans laquelle une deuxième fréquence de sortie (L*S*fo) de l'oscillateur est générée sur la base d'une deuxième valeur ($CW_2$) du signal numérique appliqué pour obtenir un deuxième nombre de comptage ($N_2$) donné par le rapport d'une deuxième fréquence de référence (fr/2) proportionnelle et inférieure à la fréquence de référence et d'une deuxième fréquence de rétroaction intermédiaire (S*fo) proportionnelle à la deuxième fréquence de sortie de l'oscillateur,
   une troisième phase (D) dans laquelle une troisième fréquence de sortie (L*S*fo) de l'oscillateur est générée sur la base d'une troisième valeur ($CW_3$) du signal numérique, ladite troisième valeur ($CW_3$) du signal numérique étant fonction de la différence des deux signaux numériques précédents ($CW_1$, $CW_2$) et des deux nombres de comptage précédents (N1, N2) pour obtenir un troisième nombre de comptage (N3) donné par le rapport d'une troisième fréquence de référence (fr/4) proportionnelle et inférieure à la deuxième fréquence de référence et d'une troisième fréquence de rétroaction intermédiaire (S*fo) proportionnelle à la troisième fréquence de sortie de l'oscillateur (L*S*fo),
   une quatrième phase (E) pour changer la valeur du signal numérique en des valeurs supplémentaires ($CW_i$) si la fréquence de rétroaction intermédiaire (S*fo) proportionnelle à la fréquence de sortie de l'oscillateur n'est pas égale à une fréquence de rétroaction intermédiaire prédéterminée (S*ft) ou si la fréquence de référence précédente proportionnelle à la fréquence de référence n'est pas égale à une fréquence de référence prédéterminée ($fr_n$),

ladite quatrième phase (E) consistant à répéter la troisième phase (D) plusieurs fois jusqu'à ce que ladite fréquence de rétroaction intermédiaire (S*fo) proportionnelle à la fréquence de sortie de l'oscillateur devienne égale à la fréquence de rétroaction intermédiaire prédéterminée (S*ft) ou jusqu'à ce que ladite fréquence de référence précédente proportionnelle à la fréquence de référence devienne égale à ladite fréquence de référence prédéterminée ($fr_n$),

et une cinquième phase dans laquelle le premier signal de tension est appliqué à la première entrée dudit oscillateur (2).

2. Procédé selon la revendication 1, **caractérisé en ce que** ledit oscillateur (2) a un champ de fréquences de fonctionnement et ladite première phase comprend le réglage de la première valeur du signal numérique ($CW_1$) à la valeur correspondant à la plus haute valeur des fréquences dudit champ de fréquences de fonctionnement et ladite deuxième phase comprend le réglage de la deuxième valeur du signal numérique ($CW_1$) à la valeur correspondant à la plus basse valeur des fréquences dudit champ de fréquences de fonctionnement.

3. Procédé selon la revendication 1, **caractérisé en ce que** ledit oscillateur (2) a un champ de fréquences de fonctionnement et ladite première phase comprend le réglage de la première valeur du signal numérique ($CW_1$) à la valeur correspondant à la plus basse valeur des fréquences dudit champ de fréquences de fonctionnement et ladite deuxième phase comprend le réglage de la deuxième valeur du signal numérique ($CW_1$) à la valeur correspondant à la plus haute valeur des fréquences dudit champ de fréquences de fonctionnement.

4. Procédé selon la revendication 1, **caractérisé en ce que** la valeur supplémentaire du signal numérique ($CW_i$) est liée aux valeurs des premier et deuxième signaux numériques ($CW_{i-1}$, $CW_{i-2}$) et aux valeurs des fréquences de sortie respectives ($S*fo(CW_{i-1})$, $S*fo(CW_{i-2})$) de l'oscillateur selon une fonction qui représente une approximation du fonctionnement du même oscillateur (2).

5. Procédé selon la revendication 1, **caractérisé en ce que** les valeurs ($fr/2^{i-1}$) desdites deuxième et troisièmes fréquences de référence sont données par la première fréquence de référence (fr) divisée par $2^{i-1}$, où i est un nombre entier.

6. Procédé selon la revendication 1, **caractérisé en ce que** la valeur du signal numérique supplémentaire ($CW_i$) des troisième et quatrième phases est liée aux valeurs des premier et deuxième signaux numériques ($CW_{i-1}$, $CW_{i-2}$) et des fréquences de sortie respectives ($S*fo(CW_{i-1})$, $S*fo(CW_{i-2})$) de l'oscillateur selon une fonction linéaire (2).

7. Procédé selon la revendication 6, **caractérisé en ce que** la valeur supplémentaire du signal numérique dépend de la somme du deuxième signal numérique ($CW_i$) et de la différence entre la fréquence cible (ft) et la fréquence de sortie de l'oscillateur correspondant au deuxième signal numérique ($CW_{i-1}$) multiplié par le rapport entre la différence des deuxième et premier signaux numériques ($CW_{i-1}$, $CW_{i-2}$) et la différence entre les deux fréquences de sortie correspondantes ($fo(CW_{i-1})$, $fo(CW_{i-2})$) de l'oscillateur.

8. Procédé selon la revendication 7, **caractérisé en ce que** la valeur du signal numérique supplémentaire ($CW_3$) est définie par l'équation :

$$CW_i = CW_{i-1} \pm \frac{Diff_{i-1}}{Sb_i}$$

où

$$Sbi = \frac{Diff_{i-2} - Diff_{i-1}}{|CW_{i-2} - CW_{i-1}|}$$

avec

$$Diff_{i-1} = \frac{S \times ft}{fr_{i-1}} - N_{i-1} \quad \text{et} \quad Diff_{i-2} = 2 \times \left( \frac{S \times ft}{fr_{i-2}} - N_{i-2} \right)$$

où i est un nombre entier variable de 3 à n, où avec $CW_i$ le $i^{ème}$ signal numérique est indiqué, où $fr_i = fr/2^{i-1}$ où fr est la fréquence de référence, où $N_i$ est le nombre se rapportant au rapport entre la fréquence de sortie de l'oscillateur concernant le signal numérique $CW_i$ et la fréquence $fr_i$ et est un nombre entier, où $S \times$ ft indique la fréquence d'oscillation de l'oscillateur se rapportant à la fréquence cible ft définie extérieurement.

Fig.1

Fig.2

Fig.3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6114920 A

- WO 03044961 A

**Non-patent literature cited in the description**

- A Fully Integrated PLL Frequency Synthesizer LSI for Mobile Communication System. *IEEE Radio Frequency Integrated Circuits Symposium,* 2001, 65-68